# EUROPEAN PATENT APPLICATION

(11) **EP 4 560 688 A1**
(43) Date of publication of application: **28.05.2025**
(21) Application number: 23843289.2
(22) Date of filing: 14.07.2023
(51) Int. Cl.: H01L 21/762, H01L 21/02

(54) **METHOD FOR MANUFACTURING SEMICONDUCTOR DEVICE**

(30) Priority: 22.07.2022 KR 20220091069
(71) Applicant: HPSP Co., Ltd., Hwaseong-si, Gyeonggi-do 18449 (KR)
(72) Inventor: CHO, Sung-Kil, Gyeonggi-do 18449 (KR)
(74) Representative: HGF
(86) International application number: PCT/KR2023/010145
(87) International publication number: WO 2024/019440

(57) **Abstract**

The present disclosure relates to a method for manufacturing a semiconductor device. The method for manufacturing a semiconductor device, according to one embodiment, may comprise a gap-fill step of burying a gap-fill oxide in trenches formed on a substrate, so as to form a gap-fill oxide film. In one embodiment, the gap-fill step can comprise a high pressure oxidation (HPO) step. According to embodiments, a semiconductor device with electrical properties superior to those of a conventional semiconductor device can be manufactured.

## Description

### FIELD

The present disclosure relates to a method for manufacturing a semiconductor device.

### DESCRIPTION OF RELATED ART

When manufacturing a semiconductor device, an element isolation technique is used to electrically isolate individual elements such as transistors or capacitors from each other. Recently, in a high-integration memory device manufacturing field, a shallow trench isolation (STI) technology in which an element isolation area is formed by forming a trench in a substrate and filling the trench with a gap-fill oxide film has been applied.

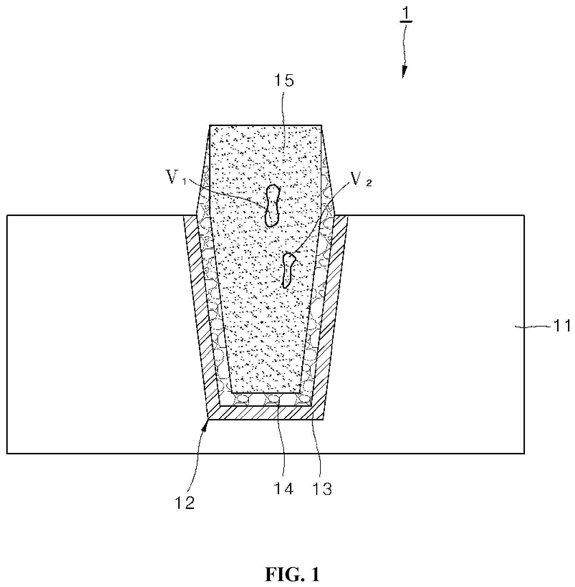

FIG. 1 is a cross-sectional view illustrating an element isolation area of a semiconductor device according to the related art.

As illustrated, a semiconductor device 1 according to the related art includes a substrate 11 and an element isolation area formed in the substrate 11. According to the related art, in a process of forming the element isolation area, a liner nitride film 13 is formed inside a trench 12, and a liner oxide film 14 is formed on the liner nitride film 13. After the liner oxide film 14 has been formed, an oxide for gap-filling is gap-filled in the trench 12 to form a gap-fill oxide film 15, and planarization is performed thereon via a chemical mechanical polishing (CMP) process to complete the element isolation area.

When a width of the trench in which the element isolation area is to be formed is 30 nm or smaller, a gap-filling limit occurs in plasma and thermochemical deposition due to the need for a high aspect ratio and a low temperature process, and thus it is essential to develop a gap-fill process using a material having flowing ability. A representative scheme using the flowing ability includes a coating scheme using spin-on-glass (SOG). However, in the case of the coating scheme using SOG, it is difficult to secure a subsequent thermal process condition for densification and stabilization of the gap-fill oxide film, and electrical characteristics of the semiconductor device may be deteriorated due to voids V₁ and V₂ in the gap-fill oxide film and the breakage of the gap-fill oxide film.

Due to the above-described problem, the gap-fill oxide film may be generated using a chemical vapor deposition (CVD) scheme rather than the coating scheme. However, according to the CVD scheme, the gap-fill oxide film may be broken due to deterioration in adhesion of the gap-fill oxide and a deformation thereof due to stress during a subsequent heat treatment, and thus, deterioration in electrical characteristics of the semiconductor device may occur.

### DISCLOSURE

### TECHNICAL PURPOSES

A purpose of the present disclosure is to provide a method for manufacturing a semiconductor device capable of reducing generation of voids in a gap-fill oxide film and simultaneously reducing a breakage phenomenon of the gap-fill oxide film.

A purpose of the present disclosure is to provide a method for manufacturing a semiconductor device having improved electrical characteristics compared to the prior art.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

### TECHNICAL SOLUTION

A method for manufacturing a semiconductor device according to one embodiment may include a gap-fill process of filling a trench formed in a substrate with a gap-fill oxide, thereby forming a gap-fill oxide film.

In one embodiment, the gap-fill process may include a high-pressure oxidation (HPO) process.

In one embodiment, the HPO process may be performed in a treatment apparatus into which at least one of O₂, O₃, H₂O, D₂O, N₂O, CO, and CO₂ is supplied.

In one embodiment, when the HPO process is performed, an internal atmospheric pressure of the treatment apparatus may be maintained at 2 to 50 atmospheres.

In one embodiment, when the HPO process is performed, an internal temperature of the treatment apparatus may be maintained at 200 to 1000°C.

In one embodiment, a flowable chemical vapor deposition (FCVD) process using the gap-fill oxide may be performed, and, subsequently, the HPO process may be performed, thereby forming the gap-fill oxide film.

A method for manufacturing a semiconductor device according to another embodiment may include etching a substrate to form a trench therein; forming a liner layer on an inner surface of the trench; forming a gap-fill oxide film on the liner layer to gap-fill an inside of the trench; and planarizing the gap-fill oxide film.

In another embodiment, the gap-fill oxide film may be formed in a gap-fill process including a high-pressure oxidation (HPO) process.

In another embodiment, the HPO process may be performed in a treatment apparatus into which at least one of O₂, O₃, H₂O, D₂O, N₂O, CO, and CO₂ is supplied.

In another embodiment, when the HPO process is performed, an internal atmospheric pressure of the treatment apparatus may be maintained at 2 to 50 atmospheres.

In another embodiment, when the HPO process is performed, an internal temperature of the treatment apparatus may be maintained at 200 to 1000°C.

In another embodiment, a flowable chemical vapor deposition (FCVD) process using the gap-fill oxide may be performed, and, subsequently, the HPO process may be performed, thereby forming the gap-fill oxide film.

In another embodiment, the liner layer may have a single-layer or multi-layer structure comprising at least one of a nitride film, an oxide film, and a polysilicon film.

### TECHNICAL EFFECT

According to the embodiments, in a process of generating the element isolation area of the semiconductor device, generation of the voids in the gap-fill oxide film is reduced, and the density of the gap-fill oxide film is increased. In addition, the breakage phenomenon of the gap-fill oxide film in a process of generating the element isolation area of the semiconductor device may be reduced. Accordingly, the semiconductor device having improved electrical characteristics compared to the prior art can be manufactured.

### BRIEF DESCRIPTION OF DRAWINGS

FIG. 1 is a cross-sectional view illustrating an element isolation area of a semiconductor device according to the related art.
FIGS. 2 to 7 illustrate a process of forming an element isolation area of a semiconductor device according to an embodiment.
FIG. 8 is a cross-sectional view of a capacitor element including a gap-fill oxide film.
FIG. 9 is a graph illustrating a leakage current value measured when a voltage is applied to each capacitor element including each of a gap-fill oxide film according to the related art and a gap-fill oxide film according to an embodiment.
FIG. 10 is a graph illustrating a charge retention time measured when a voltage is applied to each capacitor element including each of a gap-fill oxide film according to the related art and a gap-fill oxide film according to an embodiment.
FIG. 11 is a graph showing an etch rate of each of a gap-fill oxide film according to the related art and a gap-fill oxide film according to an embodiment.

### DETAILED DESCRIPTIONS

The above-described purposes, features, and advantages will be described in detail with reference to the accompanying drawings, and accordingly, a person having ordinary skill in the art to which the present disclosure belongs will be able to easily implement the embodiments of the present disclosure. In describing the present disclosure, when it is determined that a detailed description of known technologies related to the present disclosure may unnecessarily obscure a gist of the present disclosure, the detailed description thereof will be omitted. Hereinafter, preferred embodiments of the present disclosure will be described in detail with reference to the accompanying drawings. In the drawings, the same reference numerals refer to the same or similar elements.

Embodiments of the present disclosure are applicable to any method for manufacturing a semiconductor device that include a gap-fill process into a trench formed in a substrate, and forms the gap-fill oxide film via the gap-fill process without limitations.

Hereinafter, the features of the present disclosure will be described with reference to the accompanying drawings using a shallow trench isolation (STI) technique as one embodiment. However, it will be apparent to those skilled in the art that the present disclosure is not limited thereto.

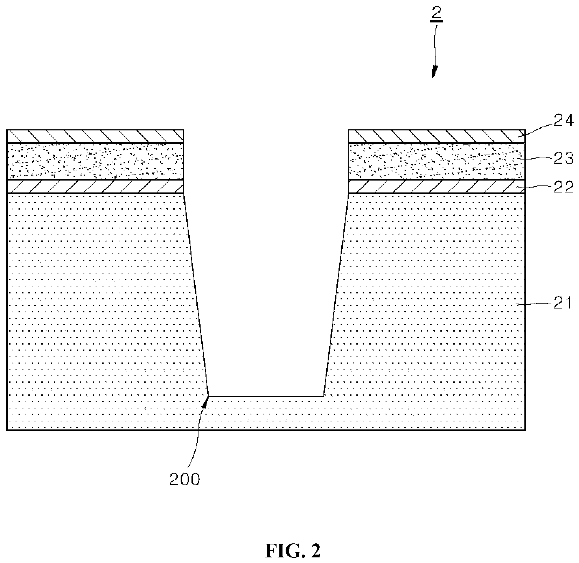

FIGS. 2 to 7 illustrate a process of forming an element isolation area of a semiconductor device according to an embodiment.

First, as illustrated in FIG. 2, a first pad oxide film 22, a pad nitride film 23, and a second pad oxide film 24 are sequentially deposited on a semiconductor substrate 21. In another embodiment, the second pad oxide film 24 may not be deposited.

The semiconductor substrate 21 may be made of at least one of Si and SiGe. In an embodiment, the semiconductor substrate 21 may be a single layer made of Si or a single layer made of SiGe. In another embodiment, the semiconductor substrate 21 may have a multilayer structure in which first layers made of Si and second layers made of SiGe are alternately stacked on top of each other.

Subsequently, a portion of each of the first pad oxide film 22, the pad nitride film 23, and the second pad oxide film 24 is etched in a patterning process and an etching process using an element isolation mask, thereby forming a trench 200 to be an element isolation area of the semiconductor substrate 21.

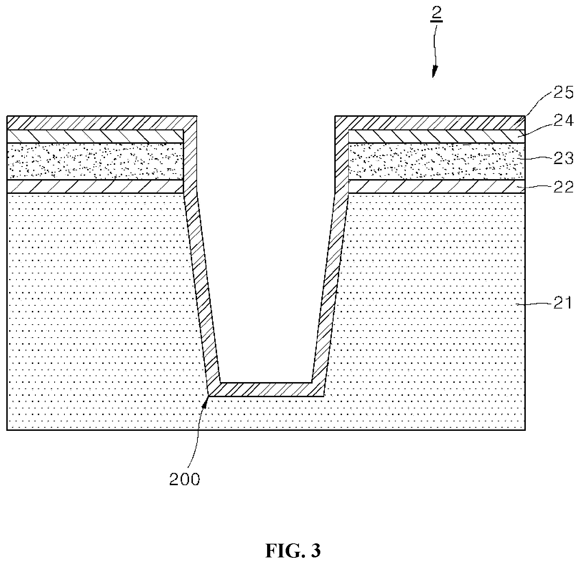

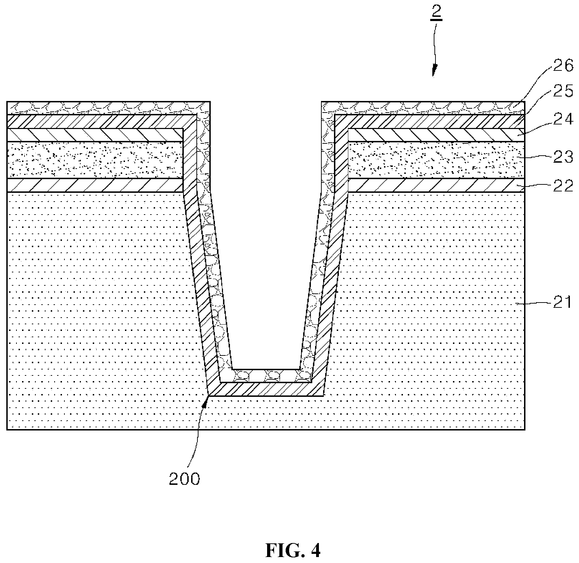

Next, a liner layer may be formed on the semiconductor device 2. For example, as illustrated in FIGS. 3 and 4, a liner nitride film 25 is first stacked on the semiconductor device 2, and the liner nitride film 25 is oxidized to form a liner oxide film 26, thereby forming the liner layer including the two layers 25 and 26.

The liner nitride film 25 compensates for compressive stress caused by a gap-fill oxide buried in the trench 200. That is, since the compressive stress applied to the semiconductor substrate 21 due to the gap-fill oxide is offset by a tensile stress of the liner nitride film 25, the electrical characteristics of the semiconductor device 2 may be prevented from being deteriorated due to the element isolation area.

In particular, the liner nitride film 25 serves to improve refresh characteristics of a cell area by preventing defects occurring in an active area of the semiconductor device 2 from diffusing into the element isolation area. A silicon nitride film (Si₃N₄) may be used as the material of the liner nitride film 25. The liner nitride film 25 may be formed by low pressure chemical vapor deposition or plasma enhanced chemical vapor deposition. However, the present disclosure is not limited thereto.

Although not shown, a wall oxide film may be formed at a surface of the trench 200 by oxidizing the surface of the trench 200 before the liner nitride film 25 is formed. The wall oxide film is intended for curing defects such as lattice defects and plasma damage that may occur during the formation of the trench 200. When the wall oxide film has been formed, the liner nitride film 25 may be formed on the wall oxide film.

The liner oxide film 26 prevents damage to the liner nitride film 25 due to formation of a gap-fill oxide film 27 when the gap-fill oxide film 27 is formed by filling the trench 200 with the gap-fill oxide.

FIGS. 3 and 4 illustrate an embodiment in which the liner layer 25 and 26 has a multilayer structure including the liner nitride film 25 and the liner oxide film 26 stacked on the liner nitride film 25. However, in another embodiment, the liner layer may be composed of a liner oxide film and a liner nitride film stacked on the liner oxide film. In still another embodiment, the liner layer may be composed of a liner oxide film and a polysilicon layer stacked on the liner oxide film.

In still another embodiment, the liner layer may have a single layer structure. For example, the liner layer may include only a polysilicon layer.

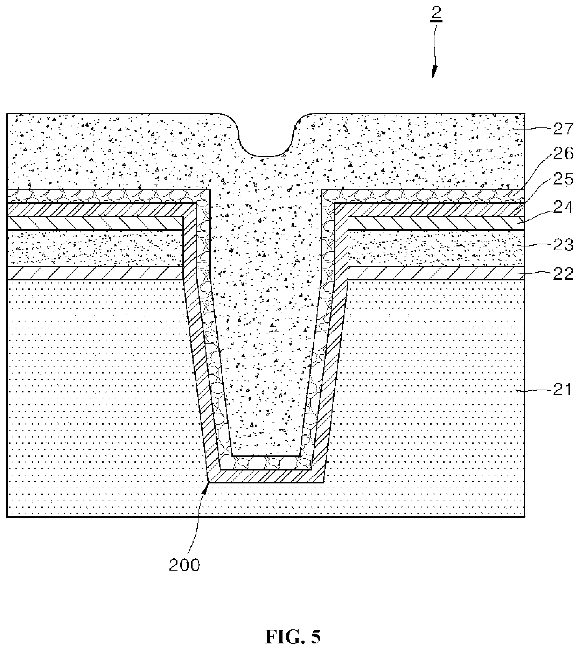

Next, as shown in FIG. 5, the gap-fill oxide film 27 is formed by filling the trench 200 with the gap-fill oxide.

In an embodiment, the gap-fill oxide film 27 may be formed in a gap-fill process including a flowable chemical vapor deposition (FCVD) process and a high-pressure oxidation (HPO) process performed after the FCVD process.

In an embodiment, the FCVD process may be performed first to form the gap-fill oxide film 27. According to the FCVD process, a film including a flowable material such as liquid or gel and including a Si component may be deposited in the trench 200 as the gap-fill oxide. After the gap-fill oxide is buried in the trench 200, curing or annealing may be performed so that materials in the gap-fill oxide may bind to each other.

After the FCVD process has been performed, the HPO process may be performed. When the HPO process is performed, a gas of at least one of O₂, O₃, H₂O (steam), D₂O (steam), N₂O, CO, and CO₂ may be supplied into a treatment apparatus (e.g., a chamber or a furnace) into which the substrate 21 has been loaded. In addition, when the HPO process is performed, an internal atmospheric pressure of the treatment apparatus into which the substrate 21 has been loaded may be maintained at 2 to 50 atmospheres. In addition, when the HPO process is performed, an internal temperature of the treatment apparatus into which the substrate 21 has been loaded may be maintained at 200°C to 1000°C. The HPO process may be performed under such conditions to form the gap-fill oxide film 27.

As described above, in the process for manufacturing the semiconductor device according to an embodiment, the gap-fill oxide film 27 may be generated in the gap-fill process including the FCVD process and the subsequent HPO process performed in an oxygen atmosphere at a high-pressure (2 to 50 atmospheres) and a low temperature (200°C to 1000°C) environment.

When the gap-fill oxide film 27 is formed using the FCVD and HPO processes that are sequentially performed as described above, voids that may be generated due to a foreign material that is removed in the process of forming the gap-fill oxide film 27 or a physical change (stress generated when the film is changed to a solid state) of the film that may occur via curing or annealing in the process of performing the FCVD process may be filled with at least one gas among O₂, O₃, H₂O (steam), D₂O (steam), N₂O, CO, and CO₂, thereby increasing the density of the gap-fill oxide film 27 compared to the related art. When the quality of the gap-fill oxide film 27 is increased, the electrical characteristics of the semiconductor device 2 may be improved compared to the related art.

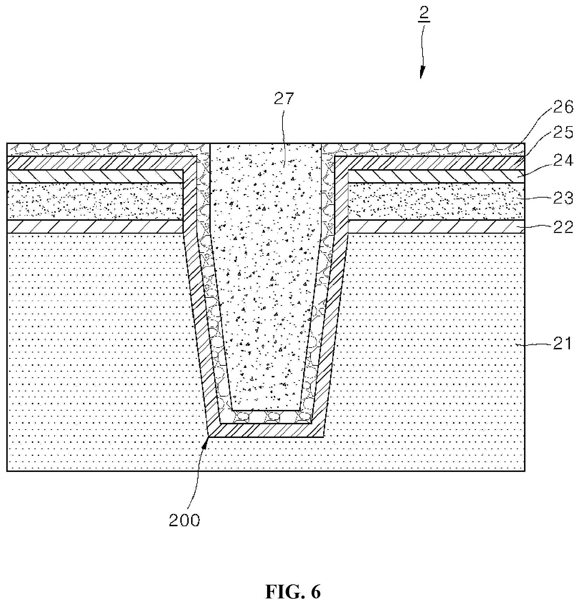

Next, as shown in FIG. 6, a chemical mechanical polishing (CMP) process is performed using the liner oxide film 26 as a polishing stop layer, thereby planarizing the gap-fill oxide film 27.

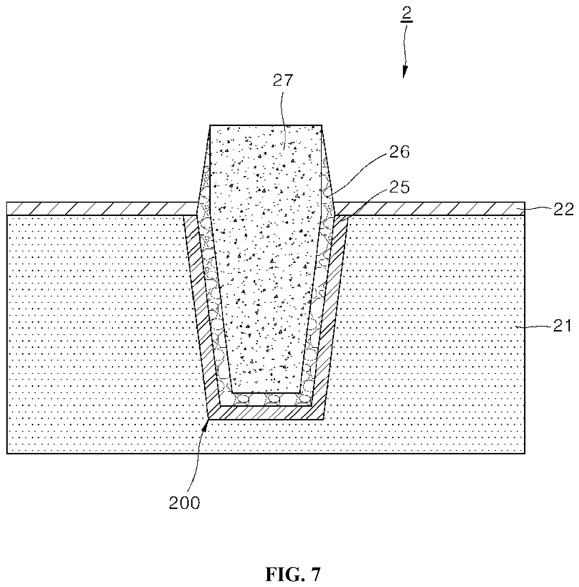

Next, as shown in FIG. 7, the liner oxide film 26, the liner nitride film 25, the second pad oxide film 24, and the pad nitride film 23 are sequentially removed, thereby completing the element isolation area.

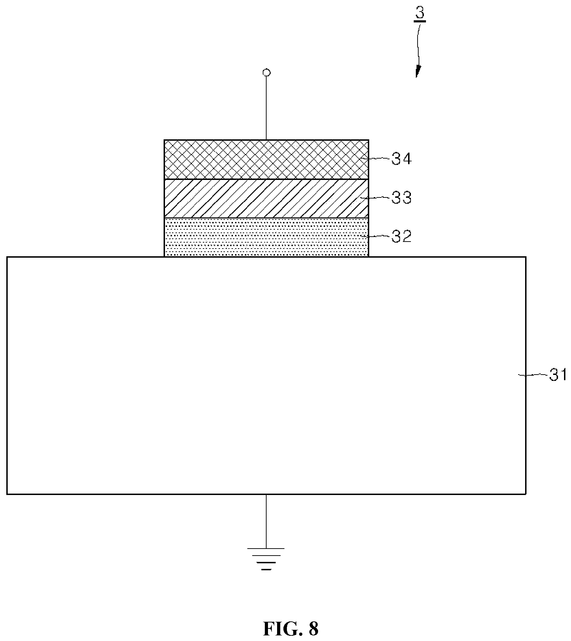

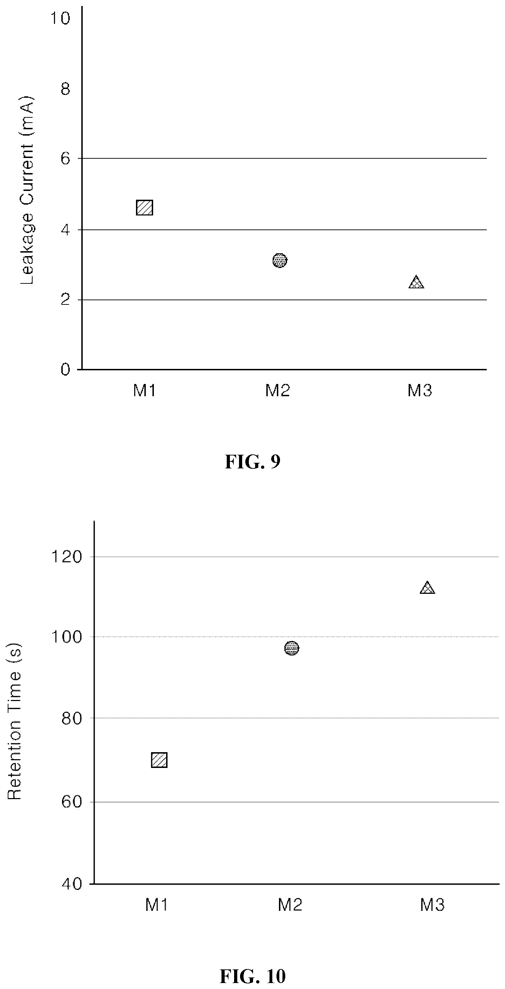

FIG. 8 is a cross-sectional view of a capacitor element including a gap-fill oxide film. In addition, FIG. 9 is a graph showing a leakage current value measured when a voltage is applied to each capacitor element including each of a gap-fill oxide film according to the related art and a gap-fill oxide film according to an embodiment. FIG. 10 is a graph showing a charge retention time measured when a voltage is applied to each capacitor element including each of a gap-fill oxide film according to the related art and a gap-fill oxide film according to an embodiment.

The capacitor element shown in FIG. 8 is fabricated for identifying the electrical characteristics of the semiconductor device including the gap-fill oxide film according to the related art and the electrical characteristics of the semiconductor device including the gap-fill oxide film according to an embodiment.

Referring to FIG. 8, a capacitor element 3 according to an embodiment includes a substrate 31, an oxide film 32, a dielectric layer 33, and an electrode 34.

The substrate 31 may be made of a material such as silicon (Si), and may be doped with P-type impurities.

In another embodiment, the substrate 31 may include at least one of Si and SiGe. For example, the substrate 31 may be a single layer made of Si or a single layer made of SiGe. In still another example, the substrate 31 may have a multilayer structure in which the first layers made of Si and the second layers made of SiGe are alternately stacked on top of each other.

The oxide film 32 is an insulating layer and may be formed by at least one of high density plasma (HDP), flowable chemical vapor deposition (FCVD), and high-pressure oxidation (HPO) processes.

The dielectric layer 33 is made of a dielectric (e.g., HfO₃) and serves to induce electrical charges between the substrate 31 and the electrode 34.

The electrode 34 may be made of a metal material (e.g., TiN).

FIGS. 9 and 10 illustrate the electrical characteristics, that is, the leakage current and the charge retention time of the capacitor element 3 as measured when a voltage is applied to the capacitor element 3 as illustrated in FIG. 8, respectively. In FIGS. 9 and 10, M1 represents a capacitor element in which the oxide film 32 is formed by the HDP process, M2 represents a capacitor element in which the oxide film 32 is formed by performing the FCVD process and then additionally performing the HDP process, and M3 represents a capacitor element in which the oxide film 32 is formed by performing the FCVD process and then additionally performing the HPO process according to the above-described embodiment.

As illustrated in FIG. 9, the magnitude of the leakage current of the capacitor element M3 including the oxide film 32 formed by performing the FCVD process and then additionally performing the HPO process according to an embodiment is smaller than the magnitude of the leakage current of each of the capacitor elements M1 and M2 including the oxide film formed by each of the processes other than the scheme according to an embodiment of the present disclosure. In addition, as shown in FIG. 10, the charge retention time of the capacitor element M3 including the oxide film 32 formed by performing the FCVD process and then additionally performing the HPO process according to an embodiment is greater than the charge retention time of each of the capacitor elements M1 and M2 including the oxide film formed by each of the processes other than the scheme according to an embodiment of the present disclosure.

Accordingly, the semiconductor device including the oxide film formed by performing the FCVD process and then additionally performing the HPO process according to an embodiment may exhibit superior electrical characteristics compared to the semiconductor device including the oxide film formed by performing the HDP process or the oxide film formed by performing the FCVD process and then additionally performing the HDP process.

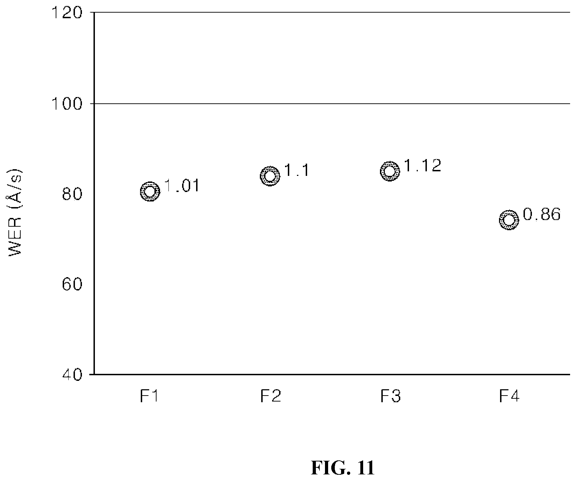

FIG. 11 is a graph showing an etch rate of each of a gap-fill oxide film according to the related art and a gap-fill oxide film according to an embodiment.

In FIG. 11, F1 represents a gap-fill oxide film formed by a general wet oxidation process, and F2 represents a gap-fill oxide film formed by a HDP process. In addition, F3 represents a gap-fill oxide film formed by performing the FCVD process and then additionally performing the HDP process, and F4 represents a gap-fill oxide film formed by performing the FCVD process and then additionally performing the HPO process according to an embodiment of the present disclosure.

FIG. 11 illustrates a wet etch rate (WER) measured when each of the gap-fill oxide films F1 to F4 is wet etched under the same condition. As illustrated in FIG. 11, an etch rate of the gap-fill oxide film F4 formed by performing the FCVD process and then additionally performing the HPO process according to an embodiment of the present disclosure is lower than an etch rate of each of the other gap-fill oxide films F1, F2, and F3. This result means that the density of the gap-fill oxide film F4 formed by performing the FCVD process and then additionally performing the HPO process according to an embodiment is higher than the density of each of the gap-fill oxide films F1, F2, and F3 formed by each of the processes other than the scheme according to an embodiment of the present disclosure. Accordingly, when the gap-fill oxide film is formed by performing the FCVD process and then additionally performing the HPO process in accordance with an embodiment, the gap-fill oxide film is densified and stabilized to increase the density of the gap-fill oxide film, thereby preventing the gap-fill oxide film from being broken in the process of forming the element isolation area.

As described above, in the method for manufacturing the semiconductor device according to the present disclosure, the gap-fill oxide film is formed by performing the gap-fill process including the high-pressure oxidation (HPO) process. In particular, the semiconductor device including the oxide film formed by performing the flowable chemical vapor deposition (FCVD) process and then further performing the high-pressure oxidation (HPO) process exhibits superior electrical characteristics compared to the semiconductor device including an oxide film formed by a conventional process.

In still another embodiment, the gap-fill oxide film may be formed by sequentially performing the FCVD process and the HPO process and then additionally performing the HDP process.

Although the present disclosure has been described above with reference to the accompanying drawings, the present disclosure is not limited by the embodiments disclosed herein and the drawings, and it is obvious that various modifications may be made by those skilled in the art within the scope of the technical idea of the present disclosure. In addition, although the effects based on the configuration of the present disclosure are not explicitly described above in the description of the embodiment of the present disclosure, it is obvious that predictable effects from the configuration should also be recognized.

## Claims

1. A method for manufacturing a semiconductor device (1), the method comprising:
a gap-fill process of filling filling a trench (200) formed in a substrate (21) with a gap-fill oxide, thereby forming a gap-fill oxide film (27),
wherein the gap-fill process includes a high-pressure oxidation (HPO) process.

2. The method for manufacturing the semiconductor device (1) of claim 1, wherein the HPO process is performed in a treatment apparatus into which at least one of O₂, O₃, H₂O, D₂O, N₂O, CO, and CO₂ is supplied.

3. The method for manufacturing the semiconductor device (1) of claim 1, wherein when the HPO process is performed, an internal atmospheric pressure of the treatment apparatus is maintained at 2 to 50 atmospheres.

4. The method for manufacturing the semiconductor device (1) of claim 1, wherein when the HPO process is performed, an internal temperature of the treatment apparatus is maintained at 200 to 1000°C.

5. The method for manufacturing the semiconductor device (1) of claim 1, wherein a flowable chemical vapor deposition (FCVD) process using the gap-fill oxide is performed, and, subsequently, the HPO process is performed, thereby forming the gap-fill oxide film (27).

6. A method for manufacturing a semiconductor device (1), the method comprising:
etching a substrate (21) to form a trench (200) therein;
forming a liner layer (25, 26) on an inner surface of the trench (200);
forming a gap-fill oxide film (27) on the liner layer (25, 26) to gap-fill an inside of the trench (200); and
planarizing the gap-fill oxide film (27),
wherein the gap-fill oxide film (27) is formed in a gap-fill process including a high-pressure oxidation (HPO) process.

7. The method for manufacturing the semiconductor device (1) of claim 6, wherein the HPO process is performed in a treatment apparatus into which at least one of O₂, O₃, H₂O, D₂O, N₂O, CO, and CO₂ is supplied.

8. The method for manufacturing the semiconductor device (1) of claim 6, wherein when the HPO process is performed, an internal atmospheric pressure of the treatment apparatus is maintained at 2 to 50 atmospheres.

9. The method for manufacturing the semiconductor device (1) of claim 6, wherein when the HPO process is performed, an internal temperature of the treatment apparatus is maintained at 200 to 1000°C.

10. The method for manufacturing the semiconductor device (1) of claim 6, wherein a flowable chemical vapor deposition (FCVD) process is performed, and, subsequently, the HPO process is performed, thereby forming the gap-fill oxide film (27).

11. The method for manufacturing the semiconductor device (1) of claim 6, wherein the liner layer (25, 26) has a single-layer or multi-layer structure composed of at least one of a nitride film, an oxide film, and a polysilicon film.
